**Europäisches Patentamt**

**European Patent Office**

**Office européen des brevets**

(11) Veröffentlichungsnummer: **0 316 000**
**A2**

# (12) EUROPÄISCHE PATENTANMELDUNG

(21) Anmeldenummer: **88118813.0**

(22) Anmeldetag: **11.11.88**

(51) Int. Cl.4: **H03M 1/12**

(30) Priorität: **12.11.87 DE 3738369**

(43) Veröffentlichungstag der Anmeldung:
**17.05.89 Patentblatt 89/20**

(84) Benannte Vertragsstaaten:
**DE FR GB**

(71) Anmelder: **DORNIER GMBH**
**Postfach 1420**
**D-7990 Friedrichshafen 1(DE)**

(72) Erfinder: **Kratz, Harald, Dipl.-Ing.**
**Untere Holunderstaffel 15**
**D-7992 Tettnang(DE)**

(74) Vertreter: **Landsmann, Ralf, Dipl.-Ing.**
**Kleeweg 3**
**D-7990 Friedrichshafen 1(DE)**

(54) **Analog/Digital-Wandler mit interner Rückkopplung.**

(57) Analog/Digital-Wandler für Betriebstemperaturen im Bereich der Supraleitung mit einem signalaufnehmenden Interferometer mit einem oder mehreren Josephson-Kontakten und einer Rückkoppeleinrichtung, wobei die Rückkoppeleinrichtung aus wenigstens einem als Komparator betriebenen Interferometer mit zwei oder mehreren Josephson-Kontakten sowie einem nachgeschalteten passiven oder aktiven Tiefpaßfilter besteht.

Fig.

EP 0 316 000 A2

## Analog/-Digital-Wandler mit interner Rückkopplung

Die Erfindung betrifft einen Analog/Digital-Wandler nach dem Oberbegriff des Anspruchs 1.

Hochauflösende Analog/Digital-Wandler auf Supraleiterbasis benötigen einen zusätzlichen Signalverarbeitungskreis um die der Auflösung entsprechende Linearität zu erzielen.

In der Patentanmeldung P 36 39 623 wurde vorgeschlagen und aus der DE-OS 35 38 186 ist bekannt, eine nachträgliche Entzerrung der gewandelten Meßwerte mit Hilfe eines Rechners vorzunehmen. Aus dem Artikel von D. Drung "Digital feedback loops for d.c. SQUID'S", Cryogenics, Vol. 26, November 1986, Seiten 623 bis 627, ist bekannt, das Signalaufnahme-SQUID in einem "flux-locked-loop" zu betreiben. Ein "flux-locked-loop" ist eine Regelschaltung, um den magnetischen Fluß in einem SQUID auf den Wert Null zu regeln.

Diesen Verfahren ist eine aufwendige Signalverarbeitung mit in konventioneller Halbleitertechnik gefertigten elektronischen Systemen gemeinsam. Bei dem Verfahren des "flux-locked-loop" kommt erschwerend hinzu, dass zwei störempfindliche Tieftemperatur-Raumtemperatur-Übergänge benötigt werden. Zwar ließen sich diese Verbindungen durch Integration der erforderlichen Bauelemente auf einem Chip einsparen, jedoch ist beim derzeitigen Stand der Josephson-Technologie die Integration eines 12-Bit oder mehr auflösenden Digital/Analog-Wandlers noch sehr fraglich.

Der Erfindung liegt die Aufgabe zugrunde, einen Analog/Digital-Wandler anzugeben, der ohne störempfindliche Übergänge im Temperaturbereich der Supraleitung arbeitet.

Diese Aufgabe wird durch die in Anspruch 1 angegebenen Merkmale der Erfindung gelöst.

Die Erfindung stellt eine bereits beim heutigen Stand der Josephson-Technologie verwirklichbare Lösung der Aufgabe auf der Basis einer internen Rückkopplung dar, wobei sich alle Elemente problemlos auf einem Chip integrieren lassen. Dies bedeutet, dass alle die Empfindlichkeit des A/D-Wandlers bestimmenden Teile bei der Betriebstemperatur des Signalaufnahme-SQUID'S betrieben werden können, was zusätzliche Vorteile bezüglich der erreichbaren Auflösung des A/D-Wandlers bringt. Die noch notwendigen Verbindungen zu einer Auswerteelektronik und Steuerelektronik, die bei Raumtemperatur arbeitet, ist unkritisch, da es sich nur um reine Taktleitungen und Versorgungsleitungen handelt.

Die Erfindung wird anhand einer Figur näher erläutert.

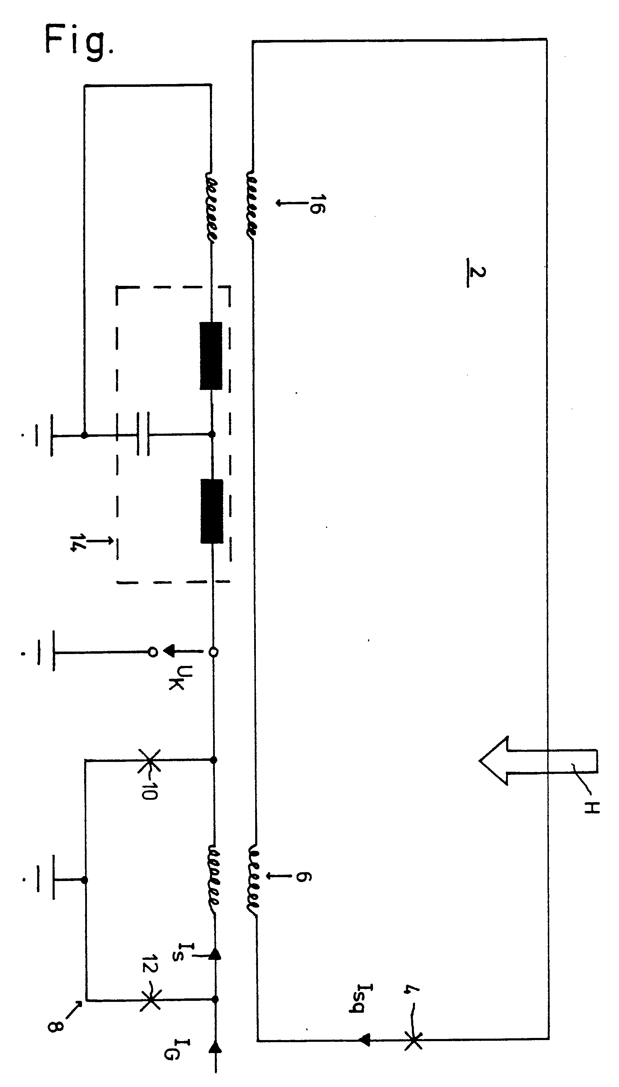

Die Figur zeigt eine Prinzipschaltung des Analog/Digital-Wandlers mit interner Rückkopplung.

Das zu messende Signal, beispielsweise ein externes Magnetfeld H, durchsetzt die signalaufnehmende Spule und erzeugt im AC-SQUID 2 mit Josephson-Kontakt 4 einen Abschirmstrom $I_{sq}$.

Durch die induktive Ankopplung über den Übertrager 6 wirkt dieser Abschirmstrom als Steuerstrom $I_s$ im Komparator-SQUID 8. Das Komparator-SQUID 8 mit zwei Josephson-Kontakten 10 und 12 wird mit einem hochfrequenten symmetrischen Taktsignal $I_G$ bis kurz vor die positive oder negative Schaltschwelle so ausgesteuert, dass bei $I_{sq} = 0$, entsprechend H = 0, die Komparator-Ausgangsspannung $U_K$ im zeitlichen Mittel gerade Null ist. Für $I_{sq} = 0$, entsprechend H = 0, schaltet das Komparator-SQUID 8 je nach Vorzeichen von $I_{sq}$ während einer Taktperiode in den positiven oder negativen Spannungszustand.

Die entstehende Pulsfolge der Ausgangsspannung $U_K$ wird von einer entsprechenden Elektronik (hier nicht gezeigt) ausgezählt. Die Auszählung kann sowohl bei Raumtemperatur als auch bei Tieftemperatur vorgenommen werden. Das zu messende Signal H liegt dann digitalisiert als Zählerstand vor. Zur internen Rückkopplung wird die Spannung $U_K$ nun einem geeignet dimensionierten Tiefpaßfilter 14 zugeführt. Die Pulsfolge $U_K$ wird dabei zeitlich gemittelt und kann als analoges Rückführsignal mittels Übertrager 16 induktiv in das AC-SQUID 2 eingekoppelt werden. Damit ist die interne Regelschleife geschlossen.

Statt einer induktiven Ankopplung ist auch eine induktiv/galvanische Ankopplung möglich. Beispielsweise können das rückzuführende Signal induktiv und die zur Arbeitspunkteinstellung notwendigen Gleichströme galvanisch eingekoppelt werden.

## Ansprüche

1. Analog/Digital-Wandler für Betriebstemperaturen im Bereich der Supraleitung mit einem signalaufnehmenden Interferometer mit einem oder mehreren Josephson-Kontakten und einer Rückkoppeleinrichtung, **dadurch gekennzeichnet**, dass die Rückkoppeleinrichtung aus mindestens einem als Komparator betriebenen Interferometer mit zwei oder mehreren Josephson-Kontakten sowie einem nachgeschalteten passiven oder aktiven Tiefpaßfilter besteht.

2. Analog/Digital-Wandler nach Anspruch 1, dadurch gekennzeichnet, dass die Rückkoppeleinrichtung eingangsseitig und ausgangsseitig induktiv an den Signalaufnehmer angekoppelt ist.

3. Analog/Digital-Wandler nach Anspruch 1, dadurch gekennzeichnet, dass die Rückkopplungseinrichtung eingangsseitig und ausgangsseitig induktiv/galvanisch an den Signalaufnehmer angekoppelt ist.

4. Analog/Digital-Wandler nach wenigstens einem der Ansprüche 1 bis 3, dadurch gekennzeichnet, dass signalaufnehmendes Interferometer und Rückkoppeleinrichtung auf einem Chip integriert sind.

5. Analog/Digital-Wandler nach wenigstens einem der Ansprüche 1 bis 4, dadurch gekennzeichnet, dass alle verwendeten Bauelemente und Bauelementengruppe ohne störempfindliche Temperaturbereichsübergänge im Temperaturbereich der Supraleitung einsetzbar sind.

6. Verfahren zum Betreiben eines Analog/Digital-Wandlers nach den Ansprüchen 1 bis 5, dadurch gekennzeichnet, dass das Komparator-SQUID mit einem geeigneten, hochfrequenten Taktsignal angesteuert wird und die Komparator-SQUID-Ausgangsspannung $U_K$ über das hochfrequente Taktsignal zu Null abgeglichen wird.

7. Verfahren nach Anspruch 6, dadurch gekennzeichnet, dass die Rückkoppeleinrichtung je nach Dämpfung des Komparators ohne externes Taktsignal betrieben wird.

8. Verfahren nach den Ansprüchen 6 oder 7, dadurch gekennzeichnet, dass bei Ausgangsspannungen $U_K$ ungleich Null die Ausgangsspannung $U_K$ einem Tiefpaßfilter zugeführt wird und anschließend in das signalaufnehmende SQUID übertragen wird.

Fig.